# EUROPEAN PATENT SPECIFICATION

(11) **EP 0 813 075 B1**
(45) Date of publication and mention of the grant of the patent: **11.11.1998**
(21) Application number: 96201635.8
(22) Date of filing: 12.06.1996
(51) Int. Cl.: G01S 17/02, G01S 7/484, H03K 17/94

(54) **Proximity detecting device**
Vorrichtung zur Feststellung von Annäherungen
Dispositif de détection de proximité

(43) Date of publication of application: 17.12.1997
(73) Proprietor: Inter Company Computer, Engineering, Design Services, in het kort : " Concept Design", naamloze vennootschap, 8500 Kortrijk (BE)
(72) Inventor: Van Marcke, Karel Carl, 9770 Kruishoutem (BE)
(74) Representative: Quintelier, Claude

(56) References cited:
- EP-A- 0 423 102
- DE-C- 3 303 404
- US-A- 4 156 221
- US-A- 4 682 628

## Description

The present invention relates to a proximity detecting device for detecting the presence of an object in a target area, comprising a low voltage power source, a circuitry comprising switching means for producing electrical pulses and arranged for supplying these electric pulses to a light emitting diode in order to emit light pulses, and a receiver for reception of light pulses emitted from the light emitting diode (LED) and directed towards said target area, said receiver being arranged to receive said light pulses either directly, after reflection on one or more reflectors or after reflection on the object to be detected.

Such a device is used in particular for detecting the presence of a human or a human body part and may be used to activate all kinds of different systems such as for example alarm systems, automatic door opening systems, counting devices, automatic bathroom fittings such as hand dryers, faucet devices, urinals, toilets, showers, soap dispensers, towel dispensers, wash fountains, etc. .... Known devices for detecting the presence of an object are either passive or active. A passive device detects the presence of an object, for example on the basis of its temperature, changes in light intensity on a passive ambient light sensor, while an active device actively emits a signal, for example a light signal or an acoustic signal and detects corresponding signals which are usually reflected on the object when present in the target area. The passive devices have the advantage of requiring generally a smaller amount of energy than the active devices since they do not have to emit signals. The active devices, however, have the advantage that also objects or persons which do not or almost not move can reliably be detected, which is useful for example in case of a person using a urinal.

Commercially available active devices generally use a 12 or 6 Volts battery for delivering, through the intermediary of the switching means, electrical pulses to a LED in order to emit light pulses having a duration equal to the duration of said electrical pulses.

In practice, when use is made of a 12 Volts battery, a serial resistance of e.g. 10Ω is provided between the LED and the battery in order to reduce the voltage applied to the LED. The drawback of such a known device is that a substantial amount of energy, supplied by the battery, is lost in the serial resistance of e.g. 10Ω. Indeed, in case the LED has a voltage drop of 1.5 Volts, it can be deduced from the Ohm's law that the current through the LED is equal to 1.05A. The energy losses in the resistance of 10Ω are then 10Ω*(1.05A)² = 11W for 12 Volts in continuous mode.

A further drawback of this known active detecting device is that the LED must be energised each time for about 80 µsec in order to emit light pulses having a sufficiently far range. It is clear that the longer the pulse duration, the higher the amount of energy required for each light pulse (80µsec*1.05A = 84µAsec).

US-A-4,682,628 discloses a faucet device which is provided with an automatic active infrared detection system and connected to an AC voltage source. The infrared detection system comprises a LED driven by a pulse generator and a light detector driven in synchronism with said LED to detect only the pulses reflected by the object, in particular a hand of the user, from the LED. Just like in the above-described commercially available active devices, a serial resistance is provided between the LED and the voltage source, in this case even a serial resistance of 120Ω.

An object of the present invention is to obviate the above described drawbacks by providing a proximity detecting device requiring less energy to emit light pulses, but covering a similar or even greater target area, and allowing to emit for a same energy consumption stronger light pulses to obtain a better detection.

To this end, the device according to the invention is characterised in that said circuitry comprises a first circuitry containing a primary coil and said switching means, which are arranged for connecting the primary coil for a period of time to said low voltage power source such as to accumulate a predetermined amount of magnetic energy in the primary coil, and a second circuitry containing said light emitting diode and a secondary coil magnetically coupled to said primary coil to transform the accumulated magnetic energy by mutual induction upon opening said switching means each time into one of said electrical pulses, said receiver being alternatively arranged to receive said light pulses directly without reflection from the target.

It has been found that when generating electrical pulses of a considerably shorter duration but having a higher amplitude by means of the magnetically coupled primary and secondary coils, it is possible to use less energy for emitting light pulses over a predetermined target area. In other words, the LED system has surprisingly a higher efficiency when providing it with electrical pulses of a higher energy level and a shorter time, the LED itself being able to resist such higher energy levels in case of a sufficiently short duty cycle.

A further important advantage of using the magnetically coupled primary and secondary coils is that the primary coil can be loaded directly by means of the low voltage source, in particular by means of a battery, i.e. without the intermediary of a serial resistance to reduce the voltage of the power source and thus without the energy losses associated therewith.

According to a first preferred embodiment of the device according to the invention, the proportion of the number of windings of the primary coil to the number of windings of the secondary coil is at least equal to about 100. This enables to generate electrical current peaks having theoretically an amplitude of at least 100 times the amplitude of the current supplied in the first circuitry. In practice, some energy losses have to be taken into account.

According to a second preferred embodiment of the device according to the invention, said primary and secondary coil are wound over one another around a same core. This enables to restrict the energy losses occurring when transforming the accumulated magnetic energy into electrical pulses. Preferably, said core is a ferrite core. Ferrite shows adequate hysteresis properties to restrict the energy losses to a minimum and to produce very short electrical pulses.

According to a fourth preferred embodiment, the device according to the invention comprises means for determining the voltage of the low voltage power source, means for determining the period of time required to accumulate said predetermined amount of magnetic energy on the basis of the voltage of the low voltage power source and timer means for closing said switching means each time for said period of time. This enables to generate electrical pulses of a constant energy level for the LED, even if the power source, in particular the battery, has lost an amount of voltage upon extended use. Consequently, less expensive batteries can be used, for example alkaline batteries instead of lithium batteries.

More details and advantages of the invention will become clear from the following description of a device according to the invention.

Figures 1 and 2 illustrate schematically the main components of a part of the circuitry of the device according to the invention having the switching means respectively closed and open.

Figure 3 illustrates the current flowing in the first and second circuitry.

Figure 4 illustrates schematically an electronic circuitry of the device according to the invention.

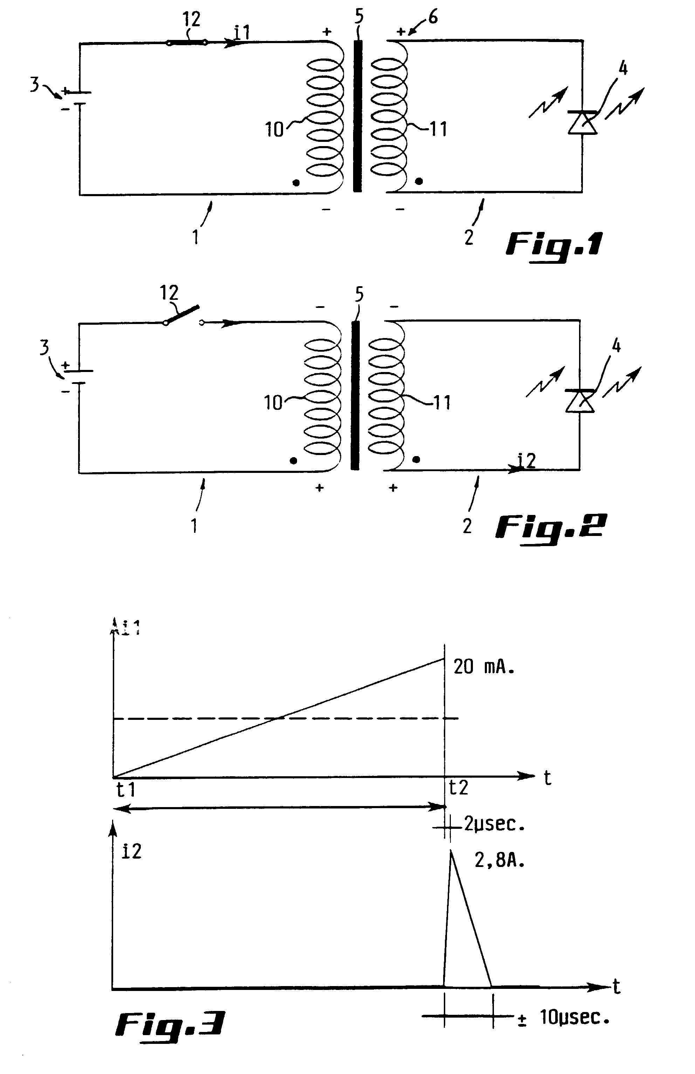

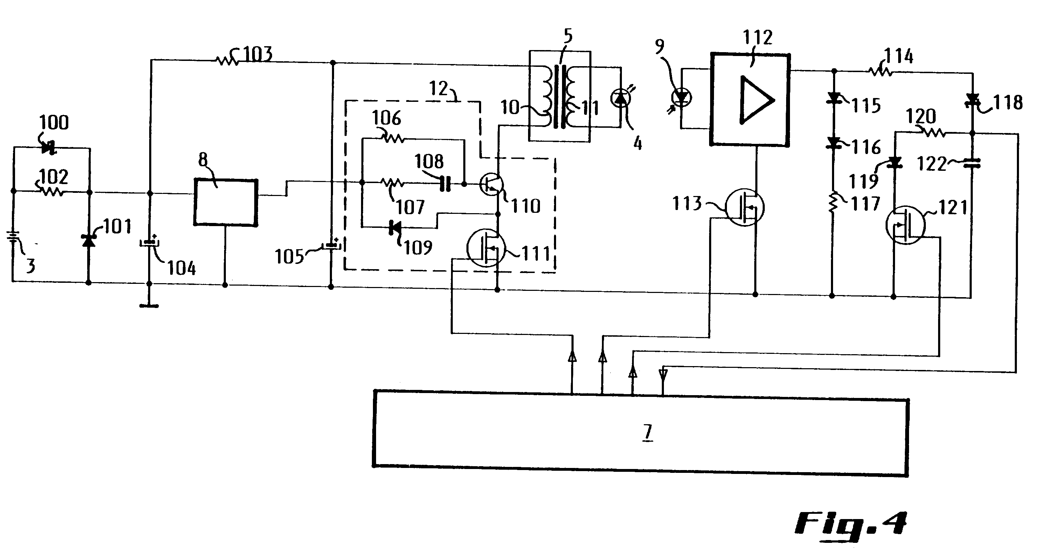

As illustrated in Figure 1, the device according to the invention comprises a first circuitry 1 and a second circuitry 2. The first circuitry 1 comprises a primary coil 10 and switching means 12, for connecting the primary coil 10 for a period of time to a power source, in particular to a battery 3 such as to accumulate a predetermined amount of magnetic energy in the primary coil 10. The second circuitry 2 comprises a light emitting diode (LED) 4 and a secondary coil 11 which is magnetically coupled to the primary coil 10. This can be done by disposing both coils around a same core, for example around the two legs of a closed U-shaped core. Preference is however given to disposing both coils over one another around the same core 5. In this way, energy losses can be restricted to a minimum.

In the embodiment shown in Figures 1 and 2, the primary and secondary coils 10 and 11 have the same winding direction, but it is clear that they may have alternatively opposite winding directions. When accumulating magnetic energy in the coils by closing the switching means 12 so that a current i1 flows through the primary coil 10 as shown in Figure 1, a voltage will be generated in the secondary coil 11, having the polarity indicated by 6, but due to the direction of the LED 4, no current can flow in the second circuitry. When opening the switching means 12 as shown in Figure 2, the current i1 through the primary coil 10 and thus also the magnetic field generated thereby drops suddenly to 0, as a result of which an electromotive force is generated by mutual induction in the secondary coil 11. This electromotive force has the opposite polarity of the electromotive force generated when the magnetic energy was accumulated in the coils so that a current i2 can now flow through the LED 4.

Upon opening the switching means 12, the magnetic energy is very quickly transformed by mutual induction into an electrical pulse in the second circuitry 2. The number of windings n1 in the primary coil 10 is higher than the number of windings n2 in the secondary coil 11, allowing to generate electrical pulses of a higher current level than the electrical current supplied by the power source 3 to the primary coil 10. Preferably, the proportion of the number of windings n1 in the primary coil 10 to the number of windings n2 in the secondary coil 11 is at least equal to about 100, and the primary coil has a number of windings of at least about 300. This enables to transform the accumulated energy into a high peak current and this during a short period of time. In view of the allowable duty cycle of the LED for such high peak currents, the generated pulses should more particularly have a raising edge of a duration which is preferably shorter than 10µsec.

Preferably, the core 5 connecting the primary coil with the secondary coil is a ferrite core, since such a material shows adequate hysteresis properties which enable to restrict the energy losses to a minimum and which further enable to achieve the required short pulse duration.

A specific example of the embodiment of Figures 1 and 2 will now be given with reference to Figures 3 and 4.

### EXAMPLE

In this example, a device with the following parameters has been chosen : a battery of 9V, number of windings n1 in the primary coil 10 equal to 707, and number of windings n2 in the secondary coil 11 equal to 5, the core being a ferrite core.

Figure 3 illustrates the current flow in the first, respectively the second circuitry. When closing the switching means 12 at the moment t1, a current i1 flows in the first circuitry 1 which increases due to the presence of the primary coil 10 linearly in time. Upon opening the switching means 12 at the moment t2, a peak current i2, having a short duration, more particularly a raising edge of only about 2 µsec, flows in the second circuitry 2 and thus through the LED 4.

In this example, the current in the first circuitry was 0 mA at t1 and 20 mA at t2, while t2-t1 was equal to 366 µsec. From the Lenz law, it can now be deduced that in case the energy losses are negligible, the self induction L1 in the primary coil 10 is equal to :$\frac{\text{9} \text{V} {\text{*366*10}}^{\text{-6}} \text{s}}{{\text{20*10}}^{\text{-3}} \text{A}} \text{≅ 0.165} \text{Henry}$

Since both coils are wound on the same core, the induction in one winding of the primary coil 10 is equal to the induction in one winding of the secondary coil. It can therefore be deduced that :$\frac{\text{L} \text{1}}{\text{L} \text{2}} \text{=} \frac{\text{n} {\text{1}}^{\text{2}}}{\text{n} {\text{2}}^{\text{2}}} \text{=} {\text{k}}^{\text{2}}$ wherein L2 is the mutual induction in the secondary coil 11, n1 is the number of windings in the primary coil, n2 is the number of windings in the secondary coil and k is the proportion of the number of windings in the primary coil to the number of windings in the secondary coil.

In case the energy losses upon transforming the magnetic energy into electrical energy are negligible, the amount of energy E in the first circuitry is equal to the amount of energy E in the second circuitry. Starting from the formulae of the amounts of energy in both circuits, the following deduction can be made :$\text{E} \text{=} \frac{\text{i} {\text{1}}_{\text{max}}^{\text{2}} \text{*} \text{L} \text{1}}{\text{2}} \text{=} \frac{\text{i} {\text{2}}_{\text{max}}^{\text{2}} \text{*} \text{L} \text{2}}{\text{2}}$ 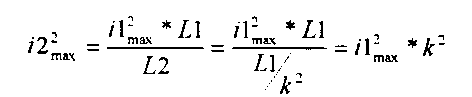 $\text{i} {\text{2}}_{\text{max}} \text{=} \text{i} {\text{1}}_{\text{max}} \text{*} \text{k}$ wherein i1ₘₐₓ is the maximum current in the first circuitry and i2ₘₐₓ is the maximum current in the second circuitry. In this example is k equal to about 141 and i1ₘₐₓ to about 20mA so that i2ₘₐₓ will be approximately equal to about 2.8A.

On the basis of the data shown in Figure 3, the energy consumption required for emitting the light pulses can easily be calculated. Indeed, in the present example the battery is connected to the primary coil for 366µsec, providing a current i1 having an average value of 10mA. If the device is provided for generating one electrical pulse per second the duty cycle δ of the device will be :$\text{δ =} \frac{{\text{366*10}}^{\text{-6}} \text{sec}}{\text{1sec}} \text{= 0.000366}$

This means that the average current consumption of the battery is 3.66 µA and that the energy consumption for generating one electrical pulse per second is 10mA*0.000366*9V*3600s/h = 118.6 mJ/h. In practice, the battery provides also current to the periphery, which is not taken into consideration herein. The known device described in the introduction shows on the contrary an average energy consumption when generating one pulse per second of 1.05A*0.00008*12V*3600s/h = 3.63J for 1 hour which is about 30 times more than the energy consumption of the device according to the invention.

Figure 4 illustrates schematically an electronic circuitry in a particular embodiment of the device according to the invention. The following table gives the identification or component values of components indicated in Figure 4 by a reference numeral.

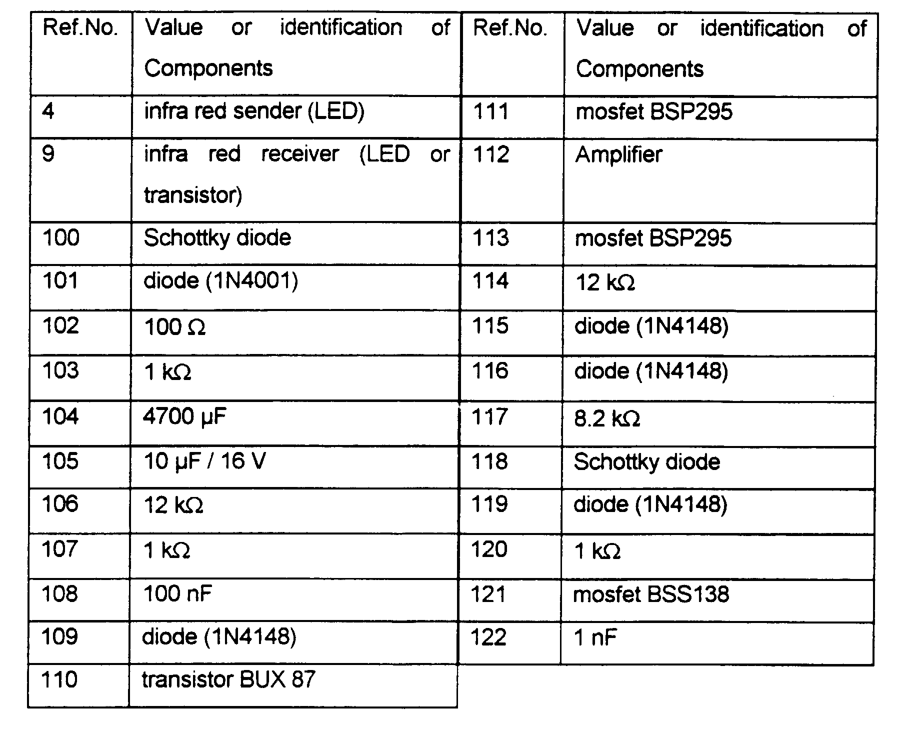

Since a circuit designer of ordinary skill in the art could build and use this circuitry as a result of this information, a detailed description of the signal paths and functions of the various components need not be undertaken. Instead, certain features of these circuits will be highlighted in the discussion below.

Under control of timer means in the microcontroller 7, the switching means 12 are opened and closed for disconnecting and connecting the primary coil 10 for a period of time to the battery 3, as explained hereinabove. As switching means 12, use is made of a cascode circuit 106-111 comprising a transistor 110, resistors 106 and 107, a capacitor 108, a diode 109 and a mosfet 111, such as illustrated in Figure 4. Such a cascode circuit, which is also known as emitter switching, is known per se and allows to switch the transistor 110 very quickly on and off, which is required to resist to high voltage peak values. Transistor 110 can resist to the high voltage peak values, which is caused by the primary coil 10 when opening the switching means, while mosfet 111, due to the other elements of the cascode circuit, must only resists to a voltage of 5V supplied by a voltage regulator 8.

Starting from the battery 3, the circuit comprises resistance 102 and diodes 100 and 101 in such a configuration that, in case the battery is not inserted in the right position, the generated inverse voltage is clamped to -0.7 Volts by diode 101, protecting the entire circuit from inverse polarity.

Capacitors 104 and 105 are connected as buffer capacity for outputting an activation signal, for example for opening and closing a valve in case the device according to the invention is used for an automatic faucet device. The primary and secondary coils 10 and 11 are wound around the same ferrite core 5, as explained hereinabove.

When an electrical pulse is generated, as explained hereinabove, the light emitting diode 4 emits an infra-red light beam in the target area. If an object is present in this target area, the presence of this object will be detected by means of a receiver 9 for the emitted light beam. This can be done in different ways. According to a first embodiment, the emitted signal is reflected by the object back towards the receiver 9. In case the object to be detected is for example an object of a dark colour such as dirty hands or a person wearing a dark suit, the reflected signal will have a substantially lower amplitude than the emitted signal. Especially in such a case, it is very important to have a good detection which can be achieved by the device according to the invention due to the fact that it allows to emit signals of a higher amplitude without requiring more energy. According to an alternative embodiment, the signal emitted from the LED is transmitted towards a receiver, either directly or through the intermediary of a reflector. The presence of an object is in this case detected when the emitted signal is interrupted by the object and does not reach the receiver any more or with a too low amplitude.

When the receiver 9 receives the emitted light beam, it generates a signal which is amplified by amplifier 112, passes through resistance 114 and diode 118 and charges capacitor 122. Resistance 120, diode 119 and mosfet 121 are used to discharge capacitor 122, under control of the microcontroller 7. Capacitor 122 can thus be considered as a memory, which is charged with a signal when an object is present in the target area. Under control of the microcontroller 7, the content of the capacitor 122 is read and the capacitor 122 is discharged.

Resistance 117 is a pull-down load resistor for amplifier 112. Diodes 115 and 116 create a voltage offset to match the microcontroller voltage level requirements.

In order to save energy, mosfet 113 is used to enable amplifier 112 only when a light signal is emitted. In this respect, also the periphery of the device according to the invention is preferably for about 70% of the time in stand-by or sleepmode. When an object is detected in the target area, the device will return to the active state wherein the frequency of the emitted light pulses is increased in order to enable quick responses of the device and/or wherein the emitted light pulses will have a higher energy level, in particular by varying the closing time of switch 103.

The device according to the invention may further comprise means for measuring the voltage of the battery. Such means are known per se, for example from EP-B-0 423 102. According to the invention, further means are provided, for example in the microcontroller, for determining the period of time required to accumulate the predetermined amount of magnetic energy on the basis of the measured voltage of the battery. Timer means may also be provided, for example in the microcontroller for closing said switching means each time for said period of time. These means are used by the microcontroller for adjusting the time for accumulating magnetic energy in function of the measured voltage, so that always the same amount of energy is provided to the LED.

A further function of the voltage measurement is for generating buzzer signals to inform the user that the battery has lost a predetermined amount of voltage and that the battery has to be replaced. This is described in detail in EP-B-0 423 102, which is incorporated herein by way of reference.

In summary, the present invention relates to a low voltage proximity detecting device for detecting an object in a target area. This device is provided with means providing electrical pulses having a relatively high energy level but a short duration. This enables the device according to the invention to require less energy to emit light pulses, but covering a similar or even greater target area, and allowing to emit stronger light pulses to obtain a better detection. The device according to the invention can i.a. be used as an automatic control system for bathroom fittings such as urinals or toilets, but also for example for automatic door opening systems. In the described embodiment, a battery has been used as low voltage source. It is however clear that the use of other low voltage sources, such as photo cells, can also be taken into consideration, especially in case they have to provide only energy for the detecting device as such, including the microprocessor.

## Claims

1. A proximity detecting device for detecting the presence of an object in a target area, comprising a low voltage power source (3), a circuitry comprising switching means (12) for producing electrical pulses and arranged for supplying these electrical pulses to a light emitting diode (4) in order to emit light pulses, and a receiver (9) for reception of light pulses emitted from the light emitting diode (4) and directed towards said target area, said receiver (9) being arranged to receive said light pulses after reflection on one or more reflectors or after reflection on the object to be detected, characterised in that said circuitry comprises a first circuitry (1) containing a primary coil (10) and said switching means (12), which are arranged for connecting the primary coil (10) for a period of time to said low voltage power source (3) such as to accumulate a predetermined amount of magnetic energy in the primary coil (10), and a second circuitry (2) containing said light emitting diode (4) and a secondary coil (11) magnetically coupled to said primary coil (10) to transform the accumulated magnetic energy by mutual induction upon opening said switching means (12) each time into one of said electrical pulses, said receiver being aternatively arranged to receive said light pulses directly without reflection from the target.

2. The device according to claim 1, characterised in that the proportion of the number of windings of the primary coil (10) to the number of windings of the secondary coil (11) is at least equal to about 100.

3. The device according to claim 1 or 2, characterised in that said electrical pulses have a raising edge with a duration lower than 10 µsec.

4. The device according to any one of the claims 1 to 3, characterised in that said primary and secondary coils (10, 11) are wound over one another around a same core (5).

5. The device according to claim 4, characterised in that said core (5) is a ferrite core.

6. The device according to any one of the claims 1 to 5, characterised in that said primary coil (10) has a number of windings at least equal to about 300.

7. The device according to any one of the claims 1 to 6, characterised in that it comprises means for determining the voltage of the low voltage power source (3), means for determining the period of time required to accumulate said predetermined amount of magnetic energy on the basis of the voltage of the low voltage power source (3) and timer means for closing said switching means (12) each time for said period of time.

8. The device according to any one of the claims 1 to 7, characterised in that said switching means (12) comprise a cascode circuit.

## Patentansprüche

1. Näherungsdetektiervorrichtung zum Detektieren der Präsenz eines Objektes in einem Zielbereich, mit einer Niederspannungs-Stromquelle (3), einer Schaltung mit Schalteinrichtung (12) zum Erzeugen von elektrischen Impulsen, die so ausgebildet ist, daß sie diese elektrischen Impulse einer Licht emittierenden Diode (4) zuführt, um Lichtimpulse zu emittieren, und mit einem Empfänger (9) zur Aufnahme von von der Licht emittierenden Diode (4) emittierten und in Richtung des Zielbereichs gerichteten Lichtimpulsen, wobei der Empfänger (9) so ausgebildet ist, daß er die Lichtimpulse nach Reflexion an einem oder mehr Reflektoren oder nach Reflexion an dem zu detektierenden Objekt aufnimmt, dadurch gekennzeichnet, daß die Schaltung aufweist: eine erste Schaltung (1), welche eine Primärwicklung (10) und die Schalteinrichtung (12) enthält, welche zum Verbinden der Primärwicklung (10) mit der Niederspannungs-Stromquelle (3) über einen Zeitabschnitt hinweg ausgebildet ist, um eine vorbestimmte Menge an magnetischer Energie in der Primärwicklung (10) zu speichern, und eine zweite Schaltung (2), welche die Licht emittierende Diode (4) und eine Sekundärwicklung (11) enthält, welche magnetisch mit der Primärwicklung (10) gekoppelt ist, um die gespeicherte magnetische Energie durch gegenseitige Induktion jedes mal beim Öffnen der Schalteinrichtung (12) in einen der elektrischen Impulse umzuwandeln, wobei der Empfänger alternativ so angeordnet ist, daß er die Lichtimpulse direkt ohne Reflexion von dem Ziel aufnimmt.

2. Vorrichtung nach Anspruch 1, dadurch gekennzeichnet, daß das Verhältnis der Anzahl der Windungen der Primärwicklung (10) zu der Anzahl der Windungen der Sekundärwicklung (11) mindestens gleich etwa 100 ist.

3. Vorrichtung nach Anspruch 1 oder 2, dadurch gekennzeichnet, daß die elektrischen Impulse eine Anstiegsflanke mit einer Dauer von weniger als 10µsec haben.

4. Vorrichtung nach einem der Ansprüche 1 bis 3, dadurch gekennzeichnet, daß die Primär- und Sekundärwicklung (10, 11) um denselben Kern übereinander gewickelt sind.

5. Vorrichtung nach Anspruch 4, dadurch gekennzeichnet, daß der Kern (5) ein Ferritkern ist.

6. Vorrichtung nach einem der Ansprüche 1 bis 5, dadurch gekennzeichnet, daß die Anzahl an Windungen der Primärwicklung (10) mindestens ca. 300 beträgt.

7. Vorrichtung nach einem der Ansprüche 1 bis 6, dadurch gekennzeichnet, daß sie eine Einrichtung zum Feststellen der Spannung der Niederspannungs-Stromquelle (3), eine Einrichtung zum Feststellen des Zeitabschnitts, der erforderlich ist, um auf der Basis der Spannung der Niederspannungs-Stromquelle (3) die vorbestimmte Menge an magnetischer Energie zu speichern, und eine Zeitgebereinrichtung aufweist, um die Schalteinrichtung (12) jedes mal für den genannten Zeitabschnitt zu schließen.

8. Vorrichtung nach einem der Ansprüche 1 bis 7, dadurch gekennzeichnet, daß die Schalteinrichtung (12) eine Cascodeschaltung aufweist.

## Revendications

1. Dispositif de détection de proximité pour détecter la présence d'un objet dans une aire visée, comprenant une source d'énergie basse tension (3), un montage comprenant un moyen de commutation (12) pour produire des impulsions électriques et agencé pour amener ces impulsions électriques à une diode électroluminescente (4) afin d'émettre des impulsions lumineuses, et un récepteur (9) pour la réception des impulsions lumineuses émises de la diode électroluminescente (4) et dirigées vers l'aire visée susdite, ledit récepteur (9) étant agencé pour recevoir lesdites impulsions lumineuses après réflexion sur un ou plusieurs réflecteurs ou après réflexion sur l'objet à détecter, caractérisé en ce que ledit montage comprend un premier montage (1) comprenant une bobine primaire (10) et ledit moyen de commutation (12), qui sont agencés pour connecter la bobine primaire (10) pendant une certaine période de temps à la source d'énergie basse tension (3) de manière à accumuler une quantité prédéterminée d'énergie magnétique dans la bobine primaire (10), et un second montage (2) contenant la diode électroluminescente (4) et une bobine secondaire (11) couplée magnétiquement à la bobine primaire (10) pour transformer l'énergie magnétique accumulée par induction mutuelle lors de l'ouverture du moyen de commutation (12) chaque fois en l'une de ces impulsions électriques, ledit récepteur étant agencé alternativement pour recevoir les impulsions lumineuses précitées directement sans réflexion de la cible.

2. Dispositif suivant la revendication 1, caractérisé en ce que la proportion du nombre d'enroulements de la bobine primaire (10) au nombre d'enroulements de la bobine secondaire (11) est au moins égale à environ 100.

3. Dispositif suivant l'une ou l'autre des revendications 1 et 2, caractérisé en ce que les impulsions électriques susdites ont un bord d'élévation d'une durée inférieure à 10 µsec.

4. Dispositif suivant l'une quelconque des revendications 1 à 3, caractérisé en ce que les bobines primaire et secondaire (10, 11) sont enroulées l'une sur l'autre autour d'un même noyau (5).

5. Dispositif suivant la revendication 4, caractérisé en ce que ledit noyau (5) est un noyau en ferrite.

6. Dispositif suivant l'une quelconque des revendications 1 à 5, caractérisé en ce que la bobine primaire (10) a un nombre d'enroulements au moins égal à environ 300.

7. Dispositif suivant l'une quelconque des revendications 1 à 6, caractérisé en ce qu'il comprend un moyen pour déterminer la tension de la source d'énergie basse tension (3), un moyen pour déterminer la période de temps requise pour accumuler la quantité prédéterminée d'énergie magnétique précitée sur la base de la tension de la source d'énergie basse tension (3) et un moyen de minuterie pour fermer le moyen de commutation (12) chaque fois pendant ladite période de temps.

8. Dispositif suivant l'une quelconque des revendications 1 à 7, caractérisé en ce que le moyen de commutation (12) comprend un circuit en cascode.
